Europäisches Patentamt

European Patent Office

Office européen des brevets

(19)

(11) Publication number : **0 492 935 A1**

## (12) EUROPEAN PATENT APPLICATION

(21) Application number : **91311704.0**

(22) Date of filing : **17.12.91**

(51) Int. Cl.⁵ : **H05K 7/10, H01R 13/193**

(30) Priority : **25.12.90 JP 413749/90**

(43) Date of publication of application :
**01.07.92 Bulletin 92/27**

(84) Designated Contracting States :
**DE FR GB IT**

(71) Applicant : **YAMAICHI ELECTRIC CO., LTD.**
**28-7, Nakamagome 3-chome**
**Ohta-ku, Tokyo (JP)**

(72) Inventor : **Uratsuji, Kazumi**
**22-8 Nishimagome 1-chome**
**Ohta-ku, Tokyo (JP)**

(74) Representative : **Ben-Nathan, Laurence Albert**
**et al**
**Urquhart-Dykes & Lord 91 Wimpole Street**
**London W1M 8AH (GB)**

(54) **Socket for electric part.**

(57) A socket in which a contacting portion of a contact is displaced outwardly in order to facilitate an easy insertion or removal of an electric part such as IC and the contacting portion is displaced inwardly in order to obtain an electrical contact between a contacting point of the electric part and the contacting portion, including latch portion extending downward in the opposite direction with respect to the contacting portion, the latch portion being provided with a hook portion facing downward, an acting portion of a pivotal lever being brought into contact engagement with an inner surface of the hook portion, the acting portion exerting an outward tensile force to the latch portion upon a downward pivotal operation of an operating portion of the pivotal lever while being pivoted in the inner surface of the hook portion, to displace the contacting portion outwardly in order to remove the electrical contact with the contacting point of the electric part.

F I G. 3 (A)

EP 0 492 935 A1

## BACKGROUND OF THE INVENTION

### 1. Field of the Invention

This invention relates to a zero insertion type socket for an electric part having means for displacing a contact between a contacting position and a releasing position.

### 2. Brief Description of the Prior Art

A conventional socket as represented by USP4623208 has a cantilevered arm integral with a contact itself and extending outwardly therefrom, and a curved spring portion likewise integral with the contact itself, the curved spring portion being biased in the compressing direction when the cantilevered arm is pushed down with a presser cover, to creafe an outward displacement as a component force, thereby separating a contacting portion of the contract away from a contacting point of an IC, so that the IC can be inserted or removed with no-load.

In the prior art mentioned above, a push-down operating force incurred to the presser cover and a contacting force of the contact are determined by the spring portion of the contact.

Therefore, if a spring constant is set large in order to increase the contacting force, the push-down operating force is also increased. On the contrary, if a spring constant of the spring portion is set small in order to reduce the operating force, the contacting force is also reduced. In this way, the prior art socket had an incompatible problem inherent therein. This being the case, it was difficult for the prior art to provide a design which satisfies both the conditions that the operating force is reduced as much as possible and the contacting force is increased.

In a structure wherein a spring portion is compressed by means of a pushing down operation of a cantilevered arm in order to obtain an outward displacing motion, the outward displacing amount created as a component force with respect to the pushing down force is very limited. Therefore, it had such shortcomings as that an efficient displacement is unobtainable with respect to the pushing down amount.

It also had such problems as that when the cantilevered arm is pushed down, the axis of the contact tends to be twisted with the results that a harmful displacement of the contacting portion likely occurs, and a metal fatigue tends to be accumulated in the basal portion of the cantilevered arm because of repeated applications of external force in the bending direction.

Furthermore, the conventional contact is subjected to complicated and highly technical designing conditions, such as establishment of a sectional area to the cantilevered arm in order to give a predetermined strength thereto, establishment of the above-mentioned spring constant, counter measures against twisting, and the like.

## SUMMARY OF THE INVENTION

It is therefore an object of the present invention to provide a socket for an electric part in which a push-down operating force can be reduced and a contacting force can be increased.

Another object of the present invention is to provide a socket for an electric part in which an efficient outward displacement can be obtained upon a push-down action, and therefore, a sufficient amount of outward displacement can be obtained with a limited amount of push-down action.

A further object of the present invention is to provide a socket for an electric part which is capable of more effectively solving such problems as twisting of the contact caused by push-down operations and metal fatigue of a cantilevered arm, and in which the contact can be soundly displaced after repeated use.

To solve the above objects, there is essentially provided a socket for an electric part including a space for accommodating an electric part, and a plurality of contacts arranged in parallel relation along at least two opposing sides of said electric part accommodating space, each of said contacts being provided with a contacting portion to be contacted with a contacting point of said electric part accommodated within said electric part accommodating space, and a spring portion adapted to urge said contacting portion inwardly to obtain a contacting pressure with said contacting point of said electric part, wherein said socket for an electric part further includes a pivotal lever pivotably supported along the external side of said rows of contacts for vertical pivotal movements about a fixed fulcrum, said pivotal lever having an operating portion formed on one end thereof and adapted to pivot said lever in a vertical direction, and an acting portion formed on the other end and adapted to exert an outward force to said contact, said contact having a latch portion extending in an opposite direc- tion with respect to said contacting portion, said latch portion being engaged with said acting portion, said,operating portion of said pivotal lever being urged into an upper pivotal position by said spring portion of said contact, said acting portion exerting an outward tensile force to a hook portion of said latch portion upon a downward pivotal movement of said operating portion, in order to displace said contacting portion of said contact outwardly against resiliency of said curved spring portion so as to be separated away from said contacting point of said electric part.

The above invention is advantageously applicable to a socket of the type in that a contact is displaced in the contacting direction (inward displacement) by a spring portion.

In the above-mentioned socket for an electric part, a push-down force is exerted to the operating portion of the pivotal lever. The operating portion can be pushed down directly by robot or finger. Otherwise, a presser cover vertically movable as shown in the prior art is provided to a socket, and by pushing down the presser cover by means of robot or finger, the pivotal lever can be pushed down indirectly. When the operating portion is pushed down, the pivotal lever is pivoted downwardly about an axis parallel to the row of contacts, and in association with the foregoing movement, the acting portion exerts an outward tensile force to the contact while being pivoted in the inner surface of the hook portion of the latch portion. As a result, the contacting portion of the contact is displaced outwardly against the resiliency of the spring portion and is separated apart from the contacting point of the electric part accommodated within the electric part accommodating space in order to bring the electric part into a non-arrested state. Accordingly, the electric part can be removed or inserted with no-load.

Upon removal of the push-down force exerted to the operating portion, the operating portion of the pivotal lever is pivoted upwardly by means of resiliency of the spring portion exerted to the acting portion through the latch portion, and forms a standby state for the next push-down operation. At the same time, the contact is displaced inwardly energized by the spring portion and is brought into pressure contact with the contacting point of the electric part.

In the above-mentioned socket for an electric part, the spring portion of the contact can be set to have such a spring constant as being contacted with the contacting point of the electric part with an appropriate contacting force. On the other hand, the pivotal member can be pushed down with a reduced operating force because of the principle of lever. If even the spring constant of the spring portion of the contact is set large, it does not lead directly to the increase of the push-down operating force. By appropriately establishing the distances between the pivotal fulcrum of the pivotal lever to the operation portion and acting portion, the above-mentioned operating force can be reduced. At the same time, the object for increasing the contacting force can also be achieved.

Furthermore, since the acting portion of the pivotal lever exerts an outward tensile force to the contact in the direction where the contact is to be displaced, so that it is separated away from the contacting point of the electric part, the contact can efficiently be displaced outwardly with respect to the push-down operation of the pivotal lever, and the electric part accommodating space can sufficiently be opened.

Moreover, it never occurs twisting and accumulation of metal fatigue in the cantilevered arm as in the prior art where the cantilevered arm of the contact is pushed down. And the contact can be soundly displaced even if it is used repeatedly. In addition, the acting portion of the pivotal lever exerts a tensile force while being freely pivoted in the hook-shaped inner surface of the latch portion, and the tensile of the contact and a backward displacement thereof are smoothly and properly realized by the pivotal movement of the pivotal lever.

The above and other objects, features of the present invention will be better understood from the description of the embodiment to follow with reference to the drawings.

BRIEF DESCRIPTION OF THE DRAWINGS

Fig. 1 is a perspective view showing the appearance of a socket for an electric part according to one embodiment of the present invention;
Fig. 2 is a perspective view showing the appearance of a socket for an electric part, having a presser cover;
Figs. 3(A) through 3(C) are sectional views of an important portion of the socket for an electric part, showing operating states of a pivotal lever and a contact;
Figs. 4(A) through 4(C) are sectional views of an important portion, showing operating states of the socket for an electric part having a presser cover.

DETAILED DESCRIPTION OF THE EMBODIMENT

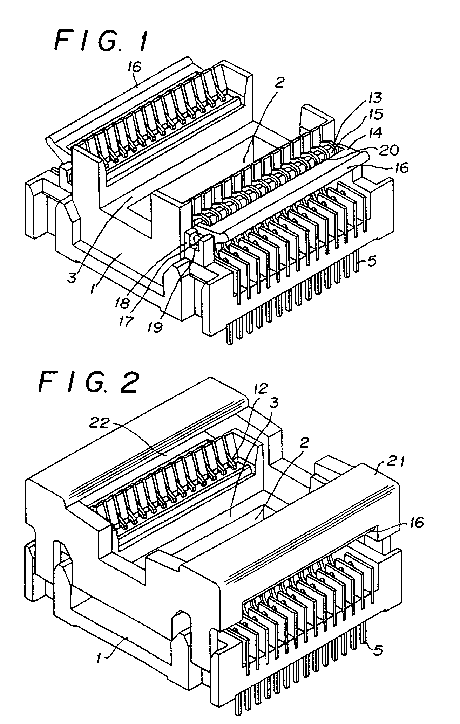

One embodiment of the present invention will be described in detail with reference to Figs. 1 through 4.

A base member 1 formed of an insulating material has a central opening 2 which is opened in upper and lower surfaces. An electric part accommodating space 3 is defined on the upper surface side of the central opening 2, and a plurality of contacts 4 are arranged in parallel relation along at least opposing two sides of the accommodating space 3.

The contacts 4 are implanted in the base member 1. Each contact 4 has a male terminal 5 projecting downward from the lower surface of the base member 1, and a plane portion 6 continuously leading to a basal portion of the mail terminal 5. The plane portion 6 is supported on and vertically raised from an upper surface of an implanting wall of the contact 4. A spring portion 7 continuously leading to an inner edge of an upper end of the plane portion 6 is provided. The spring portion 7 is formed into a curved configuration extending downwardly from a continuous portion (basal portion 8) between the spring portion 7 and the plane portion 6 and bent upwardly reaching the vicinity of the continuous portion. That is, the spring portion 7 is formed into a curved configuration facing downward, and an angle of curve is set such that a constant small space 10 is formed between the basal portion 8 and a front end 9 extending from the basal portion 8 so that the spring portion 7 is opened at an upper part thereof. The angle of curve is 180° or more and preferably 250° or more. In other words, the spring portion 7 is curved such that the front end 9 thereof reaches the vicinity of an upper end of a vertical center line Y thereof. The curved spring portion 7 is provided with a contacting arm 11 continuously leading to the front end 9 and inclining inwardly. The contacting arm 11 is provided with a contacting projection 12 continuously leading to the front. end thereof and projecting inwardly and facing downwardly.

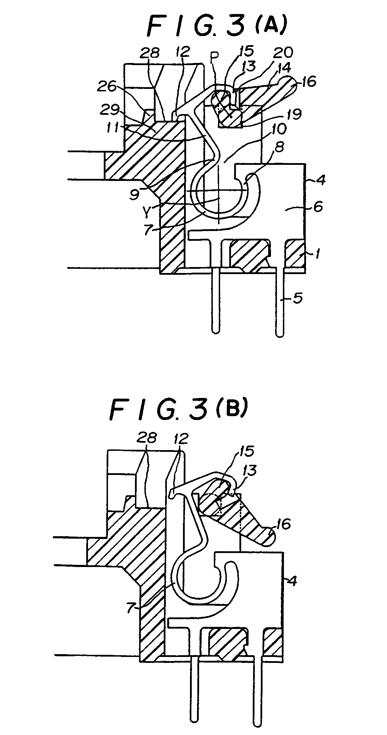

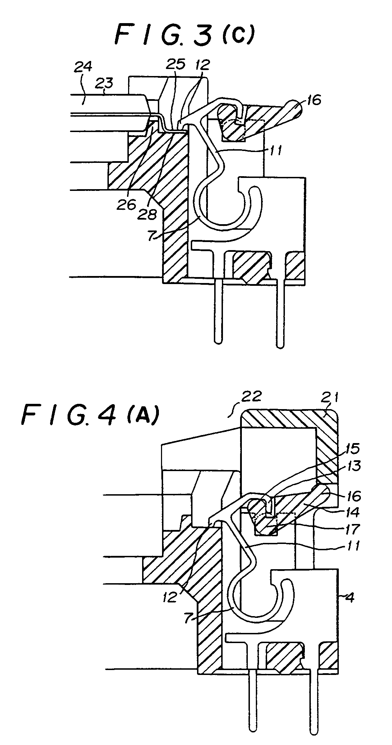

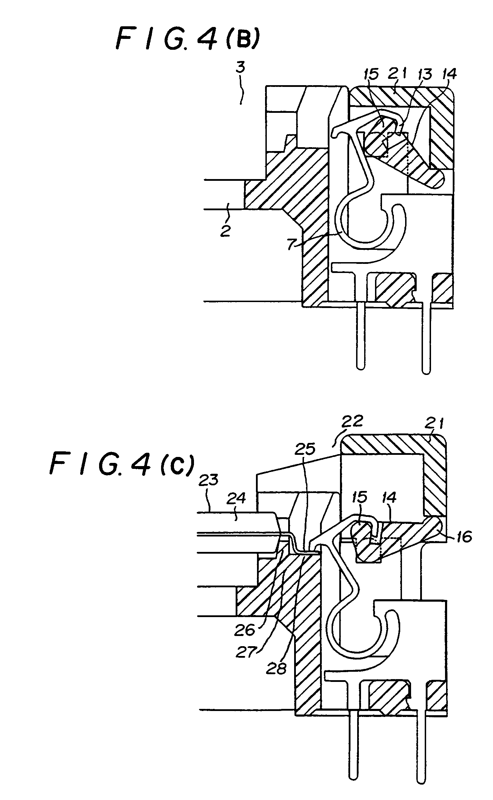

As shown in Figs. 3(A) and 4(A), the spring portion 7 acts such that the contacting arm 11 and the contacting projection 12 are urged inwardly so as to be contacted with a contacting point 25 of an electric part 23. Further, the arm 11 is provided with a latch portion 13 extending upwardly at angles from the front end thereof, i.e., from the continuous portion of the contacting projection 12. The latch portion 13 has a hook portion 13a which is formed by bending a free end of the latch portion 13 downwardly. The acting portion 15 of the pivotal lever 14 is engaged with an inner surface of the hook portion 13a. The latch portion 13 and the contacting projection 12 are disposed to a free end of the contract and extended in the opposite direction.

As shown in Fig. 1, the pivotal lever 14 is disposed long in parallel relation with the row of the contacts 4. An operating portion 16 is formed on one end of the pivotal lever 14 in such a manner as to be extended outwardly therefrom, and an acting portion 15 adapted to engage with the latch portion 13 is formed on the other end thereof. The pivotal lever 14 and its operating portion 16 and acting portion 15 are extended long in parallel relation with the row of contacts 4 at outside of the contacting arm 11, and vertically pivotable about an axial line P which is in parallel relation with the row of contacts 4. The pivotal lever 14 is provided with a shaft portion 17 extending toward the axial line P from both ends thereof, and the shaft portion 17 is rotatably supported on a bearing portion 18. The bearing portion 18 defines a recess portion 19 opened upwardly, and the shaft portion 17 is slide fitted into the recess portion 19, so that the pivotal lever 14 can be removed upwardly from the recess portion 19 or can be fitted into the recess portion 19 from above.

An engaging groove 20 extending in parallel relation with the row of contacts 4 is formed in the upper surface of the acting portion 15. By slightly loosely inserting a hook portion 13a formed by bending the tip portion of the latch portion 13 of the contact 4 into the engaging groove 20, the acting portion 15 is brought into engagement with the inner surface of the latch portion 13 in order to exert an outward force thereto. That is, the entire latch group of one row of contact group is engaged with the series of engaging groove 20. By this, the contacts 4 and the pivotal lever 14 are brought into contact engagement instead of being integrally connected.

The pivotal lever 14 is formed of an insulating material and includes the above-mentioned elements 15, 16, 20, and 17. The pivotal lever 14 is supported by axial line P so that it is pivoted about the fixed fulcrum as mentioned above. As shown in Figs. 1 and 3, the operating portion 16 can be pushed down directly by robot or manual operation, without a provision of a presser cover. Also, as shown in Figs. 2 and 4, a presser cover 21 is disposed over the base member 1. A central window 22 of the presser cover 21 is faced with the electric part accommodating space 3 of the base member 1 so that the electric part 23 can be inserted into and removed from the accommodating space 3 through the central window 22. By pushing down the presser cover 21 against the resiliency of the spring portion 7 in the foregoing state, the operating portion 16 of the pivotal lever 14 is caused to be pivoted against the spring portion 7. The electric part 23 represented by IC has a contacting point 25 projecting sideward.

As described above, the operating portion 16 of the contact 4 is pushed down directly by robot or manual operation, or otherwise the lower surface of the presser cover 21 is brought into contact with the operating portion 16 of the pivotal lever 14 and the presser cover 21 is pushed down by robot or manual operation to pushed down the operating portion 16. As a result, the pivotal lever 14, as shown in Figs. 3(B) and 4(B), is pivoted downwardly about the shaft portion 17. In association with the downward movement of the pivotal lever 14, the acting portion 15 pulls the latch portion 13 of the contact 4 outwardly while being pivoted in the inner surface of the hook portion 13a. By this outward tensile force, the contact 4 is displaced outwardly against the resiliency of the spring portion 7 so as to be separated away to a position where the contact 4 does not interfere with the contacting piece 25 of the electric part 23. Accordingly, the electric part 23 can be inserted into the accommodating space 3 with no-load or can be removed from the accommodating space 3 with no-load.

When the push-down force exerted to the operating portion 16 is removed, the hook portion 13a exerts an inward tensile force to the acting portion 15 owing to the resiliency of the spring portion 7 which is exerted to the acting portion 15. By this inward tensile force, the acting portion 15 causes the operating portion 16 to be pivoted upwardly while being pivoted in the inner surface of the hook portion 13a, to thereby form a standby state for the next push-down operation. At the same time, the contacting arm 11 and contacting projection 12 of the contact 4 are displaced inwardly urged by the spring portion 7 and brought into pressure contact with the upper surface of the contacting point 25 of the electric part 23.

A wall 27 defining the electric part accommodating space 3 is provided with a positioning ridge 26 projecting upward therefrom. The side surface of the electric part 24 is supported by the positioning ridge 26, and the lower surface of the contacting point 25 is supported by a contacting point supporting surface 28 formed on the upper surface of the wall 27 at an outer side of the positioning ridge 26. The contacting projection 12 is brought into pressure contact with the upper surface of the contacting point 25 which is in the foregoing supported state, by a downward force.

When the electric part 23 is already removed as shown in Figs. 3(A) and 4(A), the contacting projection 12 is abutted against the contacting point supporting surface 28, so that the contact 4 will not be displaced inwardly exceeding a predetermined degree. That is, the contacting point supporting surface 28 forms a stopper for limiting an inward displacing amount of the contact 4. As the result, the operating portion 16 of the pivotal lever 14 is normally pivoted upwardly to a predetermined position and held in a standby state.

According to the present invention, the spring portion of the contact can be set to such a spring constant as being able to contact the contacting point of the electric part with an appropriate contracting force, and the contact can be freely designed without being bounded by the operating force of the pivotal lever. On the other hand, the pivotal lever can be pushed down with a reduced force because of the principle of lever, and even if the spring constant of the spring portion of the contact is set large, this does not lead directly to an increase of the push-down force. By appropriately establishing distances from the pivotal fulcrum of the pivotal lever to the operating portion and acting poition, the above-mentioned operating force can be reduced. As a result, there can be achieved the object for obtaining a large amount of contacting force with a reduced operating force.

Since since the acting portion of the pivotal lever separates the contact away from the contacting point of the electric part by incurring a tensile force in the direction where the contact is displaced, the contact can efficiently be displaced outwardly upon the push-down operation of the pivotal lever with the results that a sufficient space for accommodating the electric part is obtained. Twisting of the contact caused by push-down operations of the cantilevered arm as in the prior art and accumulation of metal fatigue in the cantilevered arm can effectively be prevented, and the contact can be soundly displaced after repeated use.

Furthermore, the operating portion of the pivotal lever exerts a tensile force to the latch portion while being pivoted in the inner surface of the hook portion thereof and converts, properly and smoothly, the pivotal motion of the pivotal lever to the tensile action or outward displacing action of the contact. As a result, the contacting portion of the contact can smoothly be displaced backwardly. In addition, when the hook portion of the latch portion is exerted an outward tensile force by the pivotal lever, the downwardly curved spring portion is bent in such a manner as to narrow the upper opening favorably in response to the tensile force and causes the contacting portion to be efficiently displaced outwardly. The tensile force for biasing the spring portion can also be reduced.

## Claims

1. A socket for an electric part including a space for accommodating an electric part, and a plurality of contacts arranged in parallel relation along at least two opposing sides of said electric part accommodating space, each of said contacts being provided with a contacting portion to be contacted with a contacting point of said electric part accommodated within said electric part accommodating space, and a spring portion adapted to urge said contacting portion inwardly to obtain a contacting pressure with said contacting point of said electric part, wherein said socket for an electric part further includes a pivotal lever pivotably supported along the external side of said rows of contacts for vertical pivotal movements about a fixed fulcrum, said pivotal lever having an operating portion formed on one end thereof and adapted to pivot said lever in a vertical direction, and an acting portion formed on the other end and adapted to exert an outward force to said contact, said contact having a latch portion extending in an opposite direction with respect to said contacting portion, said latch portion being engaged with said acting portion, said operating portion of said pivotal lever being urged into an upper pivotal position by said spring portion of said contact, said acting portion exerting an outward tensile force to a hook portion of said latch portion upon a downward pivotal movement of said operating portion, in order to displace said contacting portion of said contact outwardly against resiliency of said curved spring portion so as to be separated away from said contacting point of said electric part.

2. A socket for an electric part as claimed in claim 1, wherein said spring portion of said contact has a spring configuration which is curved downwardly and opened at an upper part thereof.

3. A socket for an electric part as claimed in claim. 1, wherein a free end of said latch portion is bent downwardly to form a hook portion, and said acting portion is in engagement with said hook portion.

### F I G. 1

### F I G. 2

6

# F I G. 3 (A)

# F I G. 3 (B)

FIG. 3 (c)

FIG. 4 (A)

# F I G. 4 (B)

# F I G. 4 (C)

European Patent Office

**EUROPEAN SEARCH REPORT**

Application Number

EP    91 31 1704

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| X | GB-A-2 205 007 (WELLS ELECTRONICS INC.) <br> * page 5, line 20 - page 6, line 27; figures 2,3 * <br> --- | 1 | H05K7/10 <br> H01R13/193 |
| A,P | US-A-4 993 955 (SAVANT) <br> * abstract; figure 4 * <br> ----- | 1 | |
| | | | TECHNICAL FIELDS SEARCHED (Int. Cl.5 ) <br><br> H05K <br> H01R |

The present search report has been drawn up for all claims

| Place of search | Date of completion of the search | Examiner |
|---|---|---|
| THE HAGUE | 31 MARCH 1992 | HORAK A. L. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

............................................................

& : member of the same patent family, corresponding document

EPO FORM 1503 03.82 (P0401)